# FASCICULE DE BREVET EUROPEEN

(11) **EP 2 122 703 B1**
(45) Date de publication et mention de la délivrance du brevet: **01.08.2012**
(21) Numéro de dépôt: 08761951.6
(22) Date de dépôt: 18.01.2008
(51) Int. Cl.: H01L 41/113

(54) **DISPOSITIF PIÉZOÉLECTRIQUE AUTONOME DE GÉNÉRATION D'UNE TENSION ÉLECTRIQUE**
SELBSTHALTENDE PIEZOELEKTRISCHE VORRICHTUNG ZUR SPANNUNGSERZEUGUNG
SELF-CONTAINED PIEZOELECTRIC DEVICE FOR GENERATING VOLTAGE

(30) Priorité: 24.01.2007 FR 0752845
(43) Date de publication de la demande: 25.11.2009
(73) Titulaire: Martin, Jean-Frédéric, 38460 Cremieu (FR)
(72) Inventeur: Martin, Jean-Frédéric, 38460 Cremieu (FR)
(74) Mandataire: Palix, Stéphane
(86) Numéro de dépôt international: PCT/FR2008/050082
(87) Numéro de publication internationale: WO 2008/099122

(56) Documents cités:
- JP-A- 58 204 782
- US-A- 5 828 157

## Description

### Domaine technique

L'invention se rattache au domaine des dispositifs générateurs électriques, utilisant la conversion d'une énergie mécanique en énergie électrique par le biais d'éléments piézo-électriques.

L'invention vise plus particulièrement une nouvelle architecture mécanique d'un tel dispositif, qui procure en particulier des avantages majeurs en termes de rendements et de mise en oeuvre.

### Techniques antérieures

De façon générale, de nombreux systèmes qui utilisent les composants électriques ou électroniques requièrent une autonomie énergétique, en particulier lorsqu'ils ne peuvent être reliés ou connectés à une source d'énergie extérieure. On peut citer, en particulier, des dispositifs mobiles, ainsi que des dispositifs ou appareils fixes, implantés dans des endroits où il est difficile, complexe, ou trop coûteux d'acheminer une ligne d'alimentation électrique.

Ainsi, de nombreux appareils intègrent des batteries d'accumulateurs ou piles, qui assurent une alimentation d'énergie électrique. Toutefois, ces batteries d'accumulateurs ont une autonomie limitée qui nécessite leur remplacement régulier.

Dans certains appareils, on a proposé d'intégrer des dispositifs permettant de générer une énergie électrique par conversion d'une énergie disponible à proximité de l'appareil. On peut ainsi citer les dispositifs photo voltaïques qui convertissent une énergie lumineuse, ainsi que les dispositifs à base d'éléments piézoélectriques qui permettent de convertir une énergie mécanique en une tension électrique consécutive à la déformation de l'élément piézoélectrique.

De nombreux dispositifs de génération d'énergie électrique par effet piézoélectrique ont déjà été proposés. De tels dispositifs intègrent généralement une lame vibrante, fixée par une de ses extrémités à un support fixe, et dont l'autre extrémité libre peut se déplacer sous l'effet d'une force mécanique qui lui est appliquée. Cette force peut par exemple provenir du mouvement d'une masselotte présente en extrémité de la lame, dans le cas de la récupération d'énergie sur un système vibrant, ou bien encore d'un dispositif mécanique extérieur qui provoque l'application ponctuelle d'une force sur l'extrémité de la lame, en provoquant donc sa mise en oscillation.

Un ou plusieurs éléments piézoélectriques sont rapportés sur une face ou les deux faces de la lame, et subissent donc des déformations en même temps que cette dernière oscille. Cette déformation provoque donc l'apparition d'une tension électrique aux bornes de l'élément piézoélectrique. Cette tension peut ensuite être redressée pour charger un composant capacitif, du type condensateur, de manière à alimenter une charge. De tels dispositifs sont par exemple décrits dans les documents US 2005/0280561, EP 0 725 452, DE 296 14 851 U, ou bien encore US 7 005 778, ou US5828157.

Le point commun de tous ces mécanismes réside dans leur fonctionnement qui résulte de la déformation d'une poutre sensiblement rectiligne, et fixée à une ou deux de ses extrémités. Une telle conception présente de nombreux inconvénients. En effet, d'un point de vue énergétique, ces systèmes présentent des rendements relativement faibles, de l'ordre de quelques pourcents au maximum. Par rendement, on entend le rapport de l'énergie électrique fournie au composant capacitif situé en aval du composant piézoélectrique, divisée par l'énergie mécanique fournie au système.

Ces faibles rendements obligent donc généralement à multiplier les systèmes de conversion pour obtenir une énergie électrique en quantité satisfaisante, en augmentant donc le volume global du dispositif de conversion, ainsi que son coût.

Un autre inconvénient des systèmes de poutre vibrante réside dans le fait que le point d'accroche au support fixe est soumis à des contraintes mécaniques importantes, du fait du moment généré au niveau du point d'encastrement et de la propagation des vibrations dans le support.

Ces contraintes mécaniques obligent donc à assurer un encastrement robuste mécaniquement, et massique, qui augmente le coût du système, et impacte ses performances.

Un des objectifs de l'invention est d'obtenir un système qui soit à la fois simple de conception, tout en possédant un rendement nettement plus élevé que les systèmes existants, et qui conserve un coût raisonnable.

### Exposé de l'invention

L'invention concerne donc un dispositif piézoélectrique de génération d'une tension électrique. De façon connue, un tel dispositif comporte une lame vibrante présentant une première extrémité solidaire d'un support fixe. Cette lame présente une seconde extrémité libre, qui est apte à se déplacer sous l'effet d'une force mécanique au moins sur la branche qui comprend une extremité libre. Cette lame comporte au moins un élément piézoélectrique qui est rapporté sur une des faces de la lame. Conformément à l'invention, ce dispositif se caractérise en ce que la lame présente une configuration générale en V, possédant deux branches sensiblement planes, reliées par une portion de liaison courbée. Une première branche est solidaire du support tandis que la seconde branche comprend l'extrémité libre. Cet élément se déforme sous l'effet des oscillations de la lame, consécutives à la force mécanique en question, de manière à ainsi générer une tension électrique. Cette force peut être une impulsion mécanique appliquée sur la lame par un organe extérieur. Il peut également s'agir de la mise en oscillation de la lame par le fait de vibrations extérieures au système.

Autrement dit, l'invention consiste à utiliser une lame qui ne présente pas une géométrie plane et sensiblement rectiligne comme c'était le cas dans l'Art antérieur, mais au contraire une configuration recourbée ou pliée, ou en forme de U ou de V. C'est l'une des branches de cette lame recourbée qui subit l'impulsion mécanique ou est mise en régime oscillant par des vibrations extérieurs, générant une déformation de lame qui est fixée sur le support par la branche opposée. La zone de liaison entre les deux branches joue le rôle de ressort en se déformant de manière privilégiée, ce qui limite très fortement les contraintes mécaniques au niveau du point d'accrochage de la lame sur le support fixe.

Ces contraintes, et en particulier le moment, peuvent être quasi nulles dans le cas où les deux branches présentent des longueurs semblables. Toutefois, dans certains cas de figures, les branches peuvent présenter des longueurs différentes, dans le but d'influencer le rapport entre le mode fondamental d'oscillation et les modes harmoniques.

En pratique, la lame courbée peut adopter une configuration dans laquelle les deux branches sont quasiment parallèles, de manière à former un U, et à tout le moins forment entre elles un angle inférieur à 45°, pour adopter une configuration en V.

Différentes variantes sont envisageables en ce qui concerne la localisation du ou des éléments piézoélectriques.

Ainsi, cet élément piézoélectrique est disposé sur la seconde branche, c'est-à-dire la branche qui reçoit l'impulsion mécanique. Dans ce cas, l'élément est disposé avantageusement sur la face externe de cette branche, et préférentiellement du côté de cette branche située à proximité de la portion de liaison courbe. Plus précisément, cet élément piézoélectrique peut être disposé dans une région de la seconde branche qui s'étend depuis la portion de liaison courbe, jusqu'à un point situé à une distance comprise entre 20 et 50 % , et préférentiellement entre 25 et 35% de la longueur de la seconde branche. Autrement dit, l'élément piézoélectrique est préférentiellement disposé dans la moitié de la seconde branche située le plus près de la portion de liaison. Cette zone d'emplacement privilégiée est en particulier avantageuse pour des fonctionnements en impulsion, dans lesquels la seconde branche subit une déformation.

Dans une autre variante, un second élément piézoélectrique peut être disposé sur la première branche, c'est-à-dire celle qui est solidarisée sur le support fixe. Bien que présentant un rendement moindre que dans le cas où l'élément piézoélectrique est sur la seconde branche, cette solution peut être adoptée dans certains cas de figure.

Cet élément piézoélectrique peut être disposé sur la face interne ou externe de cette branche. Pour des raisons pratiques, il est également préférable d'implanter les éléments piézoélectriques sur la face externe de la lame. La proximité de l'élément piézoélectrique de la zone de liaison courbe peut également être avantageuse.

Dans ce cas, différentes positions peuvent être adoptées pour l'élément piézoélectrique, à proximité plus ou moins immédiate de la zone de liaison, ou bien encore plus proche du point d'ancrage et d'encastrement sur le support fixe. Ainsi, en pratique l'élément piézoélectrique peut être disposé dans une zone de la première branche s'étendant de la portion de liaison jusqu'à un point situé à une distance comprise entre 20 et 50 %, et préférentiellement entre 25 et 35% de la longueur de la première branche.

Dans un mode de fonctionnement « en vibrations », c'est-à-dire dans le cas où le dispositif est implanté sur une source de vibrations, qui se propagent jusqu'à l'élément piézo-électrique, la zone d'emplacement privilégié peut être de moindre amplitude, dans la mesure où le dispositif reçoit une quantité d'énergie sur une durée plus longue. Il est ainsi possible d'obtenir un niveau de récupération significatif avec seulement un élément piézo-électrique s'étendant sur 5 à 10% de la longueur de la branche où il est implanté. Par ailleurs, dans un mode de fonctionnement en vibration, il est envisageable de positionner l'élément piézo-électrique à une certaine distance de la portion de liaison, pour limiter les contraintes mécaniques imposés audit élément et ainsi augmenter sa durée de vie, tout en gardant un rendement élevé.

Il est également possible de combiner ces différentes variantes en disposant sur la lame vibrante plusieurs éléments piézoélectriques, situés sur la première et la seconde branche. De telles combinaisons permettent d'obtenir des rendements extrêmement intéressants, supérieurs à 25%, à comparer avec les rendements inférieurs à 3 % observés sur les systèmes de l'art antérieur. En pratique, on privilégiera pour des questions de rendement, les solutions dans lesquelles le ou les éléments piézoélectriques se trouvent au moins sur la deuxième lame.

En pratique, l'élément piézoélectrique peut être réalisé à partir de différents matériaux, et en particulier à base de titano zirconiate de plomb (PZT), mais également tout autre matériau piézoélectrique, et en particulier des matériaux monocristallins, tels que les alliages de nobiate de plomb-magnésium et titanate de plomb (PNM-PT). Pour optimiser le rendement, on choisira des éléments piézoélectriques qui s'étendent sur la quasi-totalité de la largeur de la lame, ladite lame étant réalisée en un matériau présentant des propriétés mécaniques en termes de résistance vive élastique autorisant une application de type ressort, ainsi que des propriétés dimensionnelles qui sont favorables à la génération d'un régime oscillant et à la propagation des vibrations. A titre d'exemple, on peut citer des aciers ayant des compositions de type « corde à piano » tels qu'en particulier l'acier XC 75 S, ou l'acier inoxydable X10C R Ni 18 8 (T4) écroui possédant des résistances à la rupture (Rₘ) supérieures à 1100 MPa. Il est également possible d'utiliser des matériaux polymériques, tel que par exemple le polysulfure de phénylène (PPS).

### Description sommaire des figures

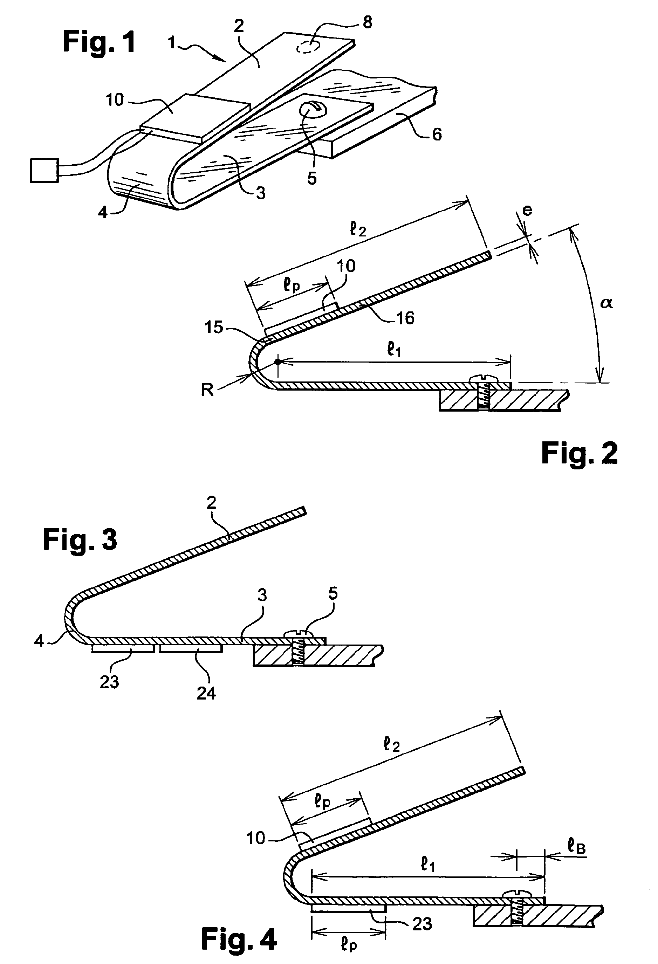

La manière de réaliser l'invention, ainsi que les avantages qui en découlent, ressortiront bien de la description des modes de réalisation qui suivent, à l'appui des figures annexées dans lesquelles :
■ la figure 1 est une vue en perspective sommaire du dispositif conforme à l'invention, réalisé selon une première variante ;
■ la figure 2 est une vue de côté du dispositif de la figure 1 ;
■ les figures 3 et 4 sont des vues de côté de deux variantes de réalisation.

La réalisation de la figure 3 est hors de l'invention.

### Manière de réaliser l'invention

Le dispositif conforme à l'invention, tel qu'illustré à la figure 1, se présente de manière générale sous la forme d'une lame (1) à base d'un matériau rigide, courbée en forme de U ou de V. Plus précisément, la lame (1) comporte deux portions sensiblement planes (2,3) formant les branches du U, reliées par une portion de liaison courbe (4). La première branche (3) est solidarisée par un moyen d'encastrement (5) sur un support fixe (6). La seconde branche (2) présente une extrémité (8) susceptible de recevoir une impulsion mécanique qui provoquera la déformation de la lame, en particulier au niveau de la zone courbée (4), puis son oscillation lorsque l'effort aura été relâché, et que la lame tendra à revenir dans sa position initiale. L'oscillation de la lame peut également résulter d'une vibration extérieure au système transmise via l'encastrement, avec la possibilité de déposer une masselotte sur l'extrémité libre (8).

Conformément à l'invention, la lame (1) est associée à au moins un élément piézoélectrique, qui dans la forme illustrée à la figure 1, se trouve positionné sur la face externe de la seconde branche (2). Cet élément piézoélectrique (10) est solidarisé par un procédé de collage classique, par exemple à base de colle époxydique.

En pratique, différents types de matériaux piézoélectriques peuvent être employés, en fonction des applications souhaitées, et des puissances nécessaires.

A titre d'exemple, on a obtenu des bons résultats en utilisant des matériaux piézoélectriques du type titano zirconiate de plomb, ou de manière plus globale, toutes les céramiques de structures cristallines perovskite De manière plus générale, de nombreux matériaux piézoélectriques peuvent être utilisés dès lors qu'ils possèdent un coefficient de couplage k₃₁ supérieur à 0,3, et un facteur de qualité mécanique supérieur à 150, dans le cas d'un fonctionnement en impulsion, ou supérieur à 30 pour la récupération d'énergie en vibrations.

En pratique, les dimensionnements et le positionnement des divers éléments peuvent être optimisés pour assurer un rendement maximum. Ainsi, comme illustré à la figure 2, l'angle α que forment les deux branches rectilignes (2,3) de la lame peut être inférieur à environ 45°, de manière à minimiser le couple et le basculement au niveau du point d'ancrage (5), lors de l'application d'une impulsion mécanique sur l'extrémité (8) de la branche (2). Dans une forme optimisée, cet angle peut être quasi nul.

La longueur des différentes branches (2,3) joue également un rôle dans l'amplitude des vibrations. Ainsi, il importe que la longueur L₂ de la seconde branche (2) soit nettement supérieure à la largeur de la lame, en particulier pour la récupération d'énergie en impulsion.

Le positionnement de l'élément piézoélectrique (10) sur la deuxième branche (2) de la lame, joue également un rôle dans le niveau de performance atteint. Ainsi, on a observé qu'il est avantageux que l'élément piézoélectrique (10) soit implanté dans une région de la seconde branche qui est située le plus proche de la zone de liaison courbe (4). Cette région de position optimale s'étend donc entre d'une part la jonction (15) de la seconde branche (2) avec la portion courbe de liaison (4), et d'autre part, un second point (16) distant du premier point (15) d'une longueur comprise entre 20 et 50 % de la longueur L₂ de la seconde branche (2). Ainsi, la longueur L_{P} de l'élément piézoélectrique (10) représente entre 20 et 50 % de la longueur L₂ de la seconde branche (2).

Le rayon de courbure (R) de la zone de liaison courbe (4) est le plus faible possible. En pratique, il est de l'ordre de quelques millimètres, fonction en particulier de l'épaisseur (e) de la lame, qui est elle-même choisie en fonction de l'épaisseur de l'élément en matériau piézoélectrique (10).

La longueur L₁ de la première branche, dont l'extrémité est fixée sur le support (6), peut être choisie sensiblement identique à la longueur L₂ de la seconde branche (2), si l'on souhaite minimiser le couple exercé au niveau du point d'ancrage (5) lors de l'application de l'impulsion mécanique ou l'oscillation libre de la lame. Toutefois, l'utilisation d'une première branche (3) d'une longueur différente peut avoir une influence sur l'amplitude des harmoniques du signal délivré par l'élément piézoélectrique (10), et donc le rendement du dispositif.

En pratique, l'élément piézoélectrique (10), peut être réalisé par l'association en parallèle de plusieurs éléments piézoélectriques unitaires.

Comme déjà évoqué, le ou les éléments piézoélectriques peuvent être implantés à divers emplacements sur la lame, et en particulier sur la première branche (3) comme illustré à la figure 3. Cette réalisation est hors de l'invention. Ainsi, le ou les éléments piézoélectrique(s) (23,24) peuvent être collés sur la face externe de la première branche (3), soit directement à proximité de la zone de liaison courbe (4), en ce qui concerne l'élément (23), soit plus proche du point d'ancrage (5) en ce qui concerne l'élément piézoélectrique (24). La longueur de chacun de ces éléments et leur positionnement précis dépend de la géométrie globale de la lame et de ses modes de vibration, de manière à optimiser le rendement énergétique.

On a obtenu de bons résultats dans la configuration illustrée à la figure 4, dans laquelle les éléments piézoélectriques sont disposés à la fois sur les deux branches de la lame. Un premier élément piézoélectrique (10) est disposé sur la seconde lame, et un deuxième élément (23) est disposé sur la face externe de la première lame, à proximité de la zone de courbure (4). Plus précisément, l'exemple particulier de réalisation décrit ci-après est donné avec des détails dimensionnés chiffrés uniquement dans le but de démontrer l'avantage de l'invention en termes de rendement. Ainsi, la lame élastique choisie est à base d'un acier ressort, du type acier inoxydable X 10 C R Ni 18 8, et présente une épaisseur (e) de 0,9 mm sur une largeur de 25 mm. La longueur L de la seconde branche (2) est de 83 mm. Le rayon de la fibre neutre de la zone courbée (4) est de 2,65 mm. La première branche bloquée (3) présente une longueur de 85 mm, sachant que le point d'encastrement (5) se trouve à une distance (d) de 33 mm par rapport à l'extrémité libre de la première branche (3). Les éléments piézoélectriques utilisés sont disposés en extrémité de leurs branches respectives, à proximité de la zone courbée (4). Les éléments piézoélectriques utilisés sont du type céramique PZT. Ces éléments sont utilisés par paires, et présentent chacun une largeur de 25 mm correspondant à la largeur de la lame, une longueur de 10 mm et une épaisseur de 0,3 mm. Leur direction de polarisation est parallèle à leur épaisseur. On peut calculer le rendement du dispositif, comme étant le rapport l'énergie électrique recueillie en sortie des éléments piézoélectriques après redressement et stockage dans un condensateur, divisée par l'énergie mécanique fournie au système. Plus précisément, l'énergie mécanique fournie au système correspond à une force d'amplitude (F) appliquée sur l'extrémité (8) de la branche libre pour provoquer un déplacement d'une course (f) de. Dans un essai avec une course de 4,4 mm, cette énergie mécanique mesurée est de 10,5 mJ. L'énergie électrique fournie par les éléments piézoélectriques se retrouve stockée dans une capacité formée par un condensateur de 5,3 µF, après redressement par un pont de diodes standard. La tension mesurée est voisine de 35,5 Volts, de sorte que le rendement correspondant est voisin de 32 %. Un autre essai, avec une flèche de 4,9 mm, et une énergie mécanique de 13,78 mJ, a permis de récupérer 3,5 mJ, dans un condensateur de 3,3 µF porté à une tension de 45,86 V, ce qui correspond à un rendement légèrement supérieur à 25%. D'autres valeurs de capacité peuvent être choisies, en fonction des contraintes électriques du dispositif, en particulier pour éviter d'avoir des tensions trop élevées.

Bien entendu, cet exemple n'est donné qu'à titre illustratif, et ne limite en aucun cas la portée de l'invention, qui peut au contraire être déclinée de manière très large tout en respectant les principes de l'invention évoqués ci-dessus.

Un tel dispositif présente de multiples avantages panni lesquels on peut citer :
■ un couplage électromécanique k supérieur à l'état de l'art, pour une quantité de matériau piézoélectrique limitée
■ un facteur de qualité mécanique défini à la conception, par exemple supérieur à l'ordre de la centaine pour la récupération d'énergie en impulsion ;
■ un moment mécanique de rotation généré au niveau du point d'encastrement qui est particulièrement réduit, voire nul, éliminant ainsi les risques de basculement du dispositif lors de la compression de la lame ;
■ l'utilisation de matériaux piézoélectriques de type courant, utilisables qui plus est en quantité réduite, avec une réduction de coût correspondante ;
■ l'utilisation de matériaux couramment disponibles pour la réalisation de la lame vibrante ;
■ un procédé de fabrication simple, conduisant à un dispositif de bonne fiabilité ;
■ un rendement très important, en comparaison avec les systèmes existant;
■ une durée de vie estimée supérieure à plusieurs dizaines d'années.
■ un système de récupération écologique et durable

### Applications industrielles

Un tel dispositif peut être utilisé de manière très large comme source d'alimentation en énergie électrique en remplacement d'accumulateurs, de piles en particulier au lithium, pour des applications de réseaux de capteurs sans fil ou pour toute application nécessitant une source d'énergie autonome, en bénéficiant d'une longue durée de vie.

On peut notamment citer les applications à des appareils de mesure des paramètres physiques dans des industries de procédé du type pétrochimie ou pharmacie. On peut mentionner les applications particulières à des capteurs de température, de pression ou de débit, et en particulier dans les circuits de distribution d'eau ou de gaz. D'autres applications concernent des appareils électriques du type interrupteurs électriques, sonnettes sans fil ou dispositifs de détection d'ouverture. Dans des versions miniaturisées, l'invention peut également être employée pour l'alimentation des systèmes micro-électro-mécaniques (MEMS).

## Revendications

1. Dispositif piézoélectrique de génération de tension électrique, comportant une lame vibrante (1) présentant une première extrémité solidaire d'un support fixe (6), et une seconde extrémité libre (8), apte à se déplacer sous l'effet d'une force mécanique (F), au moins un élément piézoélectrique (10) étant rapporté sur une face de la lame (1) pour se déformer sous l'effet des oscillations de la lame consécutives à ladite force, et ainsi générer une tension électrique, **caractérisé en ce que** la lame (1) présente une configuration générale en V, possédant deux branches (2,3) sensiblement planes, reliées par une portion de liaison courbée (4), une première branche (3) étant solidaire du support, la seconde branche (2) comportant l'extrémité libre (8), l'élément piézoélectrique (10) étant au moins sur la seconde branche (2).

2. Dispositif selon la revendication 1, **caractérisé en ce que** les deux branches sont sensiblement parallèles.

3. Dispositif selon la revendication 1, **caractérisé en ce que** les deux branches (2,3) forment entre elles un angle inférieur à 45°.

4. Dispositif selon la revendication 1, **caractérisé en ce que** l'élément piézoélectrique (10) est disposé sur la seconde branche.

5. Dispositif selon la revendication 4, **caractérisé en ce que** l'élément piézoélectrique (10) est disposé dans une zone de la seconde branche s'étendant de la portion de liaison jusqu'à un point situé à une distance comprise entre 20 et 50 %, préférentiellement entre 25 et 35% de la longueur de la deuxième branche

6. Dispositif selon la revendication 1, **caractérisé en ce que** l'élément piézoélectrique (10) est disposé sur la face externe de la seconde branche.

7. Dispositif selon la revendication 1, **caractérisé en ce que** l'élément piézoélectrique (23,24) est disposé sur la face interne ou externe de la première branche.

8. Dispositif selon la revendication 7, **caractérisé en ce que** l'élément piézoélectrique (10) est disposé dans une zone de la première branche s'étendant de la portion de liaison jusqu'à un point situé à une distance comprise entre 20 et 50 %, préférentiellement entre 25 et 35% de la longueur de la première branche.

9. Dispositif selon la revendication 1, **caractérisé en ce qu'**il comporte plusieurs éléments piézoélectriques (10, 23, 24), disposés sur la première et la deuxième branche.

10. Dispositif selon la revendication 1, **caractérisé en ce que** l'élément piézoélectrique (10) s'étend sur la quasi-totalité de la largeur de la lame (1).

11. Dispositif selon la revendication 1, **caractérisé en ce que** les deux branches (2,3) présentent des longueurs (L₁,L₂) sensiblement égales.

12. Dispositif selon la revendication 1, **caractérisé en ce que** les deux branches (2,3) présentent des longueurs (L₁,L₂) différentes.

## Claims

1. Piezoelectric device for generating a voltage, comprising a vibratory blade (1) with a first end secured to a fixed substrate (6) and a second free end (8) which can be moved by exerting a mechanical force (F) thereon, wherein at least one separate piezoelectric element (10) is provided on one side of the blade (1) in such a way that it is deformed by the oscillation of the blade following the exertion of said mechanical force, and thereby generates a voltage, **characterised in that** blade (1) is generally V shaped and has two substantially planar arms (2, 3) joined together via a curved intermediate portion (4), wherein a first arm (3) is secured to the substrate and the second arm (2) has the free end (8), the piezoelectric element (10) being located at least on the second arm (2), the piezoelectric element (10) being located at least on the second arm (2).

2. Device as claimed in claim 1, **characterised in that** the two arms are substantially parallel.

3. Device as claimed in claim 1, **characterised in that** the two arms (2, 3) form an angle of less than 45° relative to each other.

4. Device as claimed in claim 1, **characterised in that** piezoelectric element (10) is located on the second arm.

5. Device as claimed in claim 4, **characterised in that** piezoelectric element (10) is located in an area of the second arm which extends from the intermediate curved portion to a point located at a distance equal to 20 to 50% and preferably 25 to 35% of the length of the second arm.

6. Device as claimed in claim 1, **characterised in that** piezoelectric element (10) is located on the outer side of the second arm.

7. Device as claimed in claim 1, **characterised in that** piezoelectric element (23, 24) is located on the inner side or outer side of the first arm.

8. Device as claimed in claim 7, **characterised in that** piezoelectric element (10) is located in an area of the first arm which extends from the intermediate curved portion to a point located at a distance equal to 20 to 50% and preferably 25 to 35% of the length of the first arm.

9. Device as claimed in claim 1, **characterised in that** it comprises several piezoelectric elements (10, 23, 24) located on the first and on the second arm.

10. Device as claimed in claim 1, **characterised in that** piezoelectric element (10) extends over virtually the entire width of blade (1).

11. Device as claimed in claim 1, **characterised in that** the two arms (2, 3) are of substantially equal length (L₁,L₂).

12. Device as claimed in claim 1, **characterised in that** the two arms (2, 3) have different lengths (L₁,L2).

## Patentansprüche

1. Piezoelektrische Vorrichtung zum Erzeugen einer elektrischen Spannung, enthaltend eine Schwinglamelle (1) mit einem ersten Ende, das fest mit einem ortsfesten Halter (6) verbunden ist, und einem freien zweiten Ende (8), das dazu geeignet ist, sich unter der Wirkung einer mechanischen Kraft (F) zu verlagern, wobei zumindest ein piezoelektrisches Teil (10) an eine Stirnseite der Lamelle (1) angesetzt ist, um sich unter der Wirkung von auf die besagte Kraft folgenden Schwingungen der Lamelle zu verformen und damit eine elektrische Spannung zu erzeugen, **dadurch gekennzeichnet, dass** die Lamelle (1) eine V-förmige Gestalt aufweist und zwei im wesentlichen flach verlaufende Schenkel (2, 3) besitzt, die über einen gekrümmten Verbindungsabschnitt (4) verbunden sind, wobei ein erster Schenkel (3) fest mit dem Halter verbunden ist, der zweite Schenkel (2) das freie Ende (8) aufweist und das piezoelektrische Teil (10) sich zumindest am zweiten Schenkel (2) befindet.

2. Vorrichtung nach Anspruch 1, **dadurch gekennzeichnet, dass** die beiden Schenkel im wesentlichen parallel verlaufen.

3. Vorrichtung nach Anspruch 1, **dadurch gekennzeichnet, dass** die beiden Schenkel (2, 3) einen Winkel von unter 45° miteinander einschließen.

4. Vorrichtung nach Anspruch 1, **dadurch gekennzeichnet, dass** das piezoelektrische Teil (10) am zweiten Schenkel angeordnet ist.

5. Vorrichtung nach Anspruch 4, **dadurch gekennzeichnet, dass** das piezoelektrische Teil (10) in einem Bereich des zweiten Schenkels angeordnet ist, der sich von dem Verbindungsabschnitt ausgehend bis zu einem Punkt erstreckt, der sich in einer Entfernung von zwischen 20 und 50 %, vorzugsweise zwischen 25 und 35 % der Länge des zweiten Schenkels befindet.

6. Vorrichtung nach Anspruch 1, **dadurch gekennzeichnet, dass** das piezoelektrische Teil (10) an der Außenseite des zweiten Schenkels angeordnet ist.

7. Vorrichtung nach Anspruch 1, **dadurch gekennzeichnet, dass** das piezoelektrische Teil (23, 24) an der Innen- oder Außenseite des ersten Schenkels angeordnet ist.

8. Vorrichtung nach Anspruch 7, **dadurch gekennzeichnet, dass** das piezoelektrische Teil (10) in einem Bereich des ersten Schenkels angeordnet ist, der sich von dem Verbindungsabschnitt ausgehend bis zu einem Punkt erstreckt, der sich in einer Entfernung von zwischen 20 und 50 %, vorzugsweise zwischen 25 und 35 % der Länge des ersten Schenkels befindet.

9. Vorrichtung nach Anspruch 1, **dadurch gekennzeichnet, dass** sie mehrere piezoelektrische Teile (10, 23, 24) aufweist, die am ersten und am zweiten Schenkel angeordnet sind.

10. Vorrichtung nach Anspruch 1, **dadurch gekennzeichnet, dass** das piezoelektrische Teil (10) sich quasi über die gesamte Breite der Lamelle (1) erstreckt.

11. Vorrichtung nach Anspruch 1, **dadurch gekennzeichnet, dass** die beiden Schenkel (2, 3) im wesentlichen gleiche Längen (L₁, L₂) aufweisen.

12. Vorrichtung nach Anspruch 1, **dadurch gekennzeichnet, dass** die beiden Schenkel (2, 3) unterschiedliche Längen (L₁, L₂) aufweisen.
